# EUROPEAN PATENT APPLICATION

(11) **EP 2 441 812 A2**
(43) Date of publication of application: **18.04.2012**
(21) Application number: 11008229.4
(22) Date of filing: 12.10.2011
(51) Int. Cl.: C09J 5/00, H01L 21/67, H01L 21/683

(54) **Double-faced adhesive tape joining method and double-faced adhesive tape joining apparatus**

(30) Priority: 12.10.2010 JP 2010229535
(71) Applicant: Nitto Denko Corporation, Ibaraki-shi, Osaka 567-8680 (JP)
(72) Inventor: Yamamoto, Masayuki, Ibaraki-shi Osaka 567-8680 (JP)
(74) Representative: Hauck Patent- und Rechtsanwälte

(57) **Abstract**

An original master tape formed by joining pieces of a double-faced adhesive tape in a substrate shape with a separator to a long carrier tape is guided to an edge knife to travel and be folded back at the edge knife. Accordingly, the piece of the double-faced adhesive tape cut into the substrate shape is separated from the carrier tape. The separated piece of the double-faced adhesive tape is joined to a substrate relatively moving at a speed synchronized to a separation speed. It is monitored whether or not the piece of the double-faced adhesive tape is in good joining condition to the substrate to which a joining process has been performed. When poor joining is detected, the piece of the double-faced adhesive tape is separated and removed from the substrate in poor joining condition, and a piece of the double-faced adhesive tape is again joined to the substrate from which the piece of the double-faced adhesive tape is already separated and removed.

## Description

### BACKGROUND OF THE INVENTION

(1) Field of the Invention

This invention relates to a method and apparatus for joining a double-faced adhesive tape to a substrate such as a semiconductor wafer.

(2) Description of the Related Art

In recent years, a semiconductor wafer (hereinafter, appropriately referred to as a "wafer") tends to be thinned. Accordingly, in order to compensate for rigidity of the wafer under processing such as a back grinding process, a support substrate, such as a glass plate and a metal plate, that is formed into the same shape as the wafer is joined to a surface of the wafer via a double-faced adhesive tape.

For joining the support substrate having the same shape as the wafer to the surface of the wafer via the double-faced adhesive tape, the double-faced adhesive tape is firstly joined to the surface of the wafer. Thereafter, the support substrate is joined to the wafer via the double-faced adhesive tape having the wafer joined thereto. For instance, such as apparatus to which adhesive film joining apparatus is applied is adopted as apparatus for joining the double-faced adhesive tape to the surface of the wafer. See Japanese Patent Publication No. H07-195527.

Specifically, pieces of the double-faced adhesive tape pre-cut in advance in a wafer shape are joined to a long carrier tape at given intervals to form an original master tape for supply of the double-faced adhesive tape. The original master tape is feed out from an original master roll on which the tape is wound in a roll form, and is guided to an edge knife. Then, the original master tape travels while being folded back with the edge knife. At this time, the piece of the double-faced adhesive tape separates from the carrier tape with the edge knife. The separated piece of the double-faced adhesive tape is to be joined to the surface of the wafer that moves at a speed synchronized to a separation speed.

The conventional apparatus joins a long double-faced adhesive tape to a substrate, and thereafter, a cutting blade travels along a contour of the substrate for cutting out the double-faced adhesive tape. In contrast to this, with the foregoing apparatus, a joining processing time may be reduced by one time, which results in enhancement of an entire processing efficiency.

On the other hand, a piece of the double-faced adhesive tape cut out prior to a joining process is joined to the substrate. Accordingly, poor joining may possibly occur such as deviation in joining position of the piece of the double-faced adhesive tape to the substrate.

That is, an original master tape that is formed by joining the pieces of the double-faced adhesive tape to carrier tape in a roll form has different thicknesses between a portion with the piece of the double-faced adhesive tape and a portion with no piece of the double-faced adhesive tape. As a result, non-uniform winding of the tape may readily be generated during a transportation process when the tape is not sufficiently wound up.

The roll as above deforms into a cone shape. Accordingly, the tape serpentines during feeding out and transportation of the original master tape from the roll. Consequently, there arises a problem as under. That is, the substrate and the piece of the double-faced adhesive tape deviate from each other in its joining position, which leads to joining of the piece of the double-faced adhesive tape to the substrate with lower accuracy.

Moreover, in a cutting process of the piece of the double-faced adhesive tape, finishing condition of a periphery of the piece is degraded due to wear by the cutting blade. Accordingly, the piece of the double-faced adhesive tape may be joined in a state where an adhesive on the piece of the double-faced adhesive tape enters into a side of the substrate. Furthermore, when an unnecessary tape after cut out is separated under the above state, an end of the double-faced adhesive tape is split forcibly, which leads to generation of a mustache-like portion on the end.

When such poor joining occurs, the substrate is temporarily pulled out of the double-faced adhesive tape apparatus to be collected in a given position. When a given number of substrates are collected, a separating device placed individually to the double-faced adhesive tape joining apparatus separates and removes the piece of the double-faced adhesive tape from the substrate to reproduce the substrate. A given number of reproduced substrates is again returned to the double-faced adhesive tape joining apparatus.

However, in order to temporarily pull out and collect the poor-joined substrate for reproduction, it needs to prepare separately a receptacle and a place for storing the collected substrates, a transport mechanism for transporting a reproduced substrate exclusively, a mechanism for separating and removing the piece of the double-faced adhesive tape in a poor-joined condition from the substrate, a controller for controlling operations of these mechanisms, etc. Consequently, there arises such a disadvantage that not only equipment cost but also operation cost may increase.

### SUMMARY OF THE INVENTION

This invention has been made regarded to the state of the art noted above, and its primary object is to provide a method and apparatus that allow quick reproduction and reuse of a poor-joined substrate at low cost.

This invention discloses a method of joining a double-faced adhesive tape to a substrate. The method includes the steps of separating a piece of the double-faced adhesive tape with a separator cut out into a substrate shape from a long carrier tape through traveling and folding back an original master tape with an edge knife, the original master tape having the long carrier tape and the long double-faced adhesive tape joined thereto; joining the separated piece of the double-faced adhesive tape to the substrate at a speed synchronized to a separation speed; inspecting a protrusion of the joined piece of the double-faced adhesive tape from the substrate with an inspection mechanism; separating and removing the piece of the double-faced adhesive tape from the defective substrate that is transported into a tape separation mechanism when a protrusion of the piece of the double-faced adhesive tape is detected; reloading the substrate to be reproduced through returning the substrate, having the piece of the double-faced adhesive tape separated therefrom, into a tape joining position via a transport path same as that where the piece of the double-faced adhesive tape is transported from the tape joining position to the tape separation mechanism; and reproducing the substrate to be reproduced through joining a piece of the double-faced adhesive tape again to the substrate in the joining step.

According to this method, the original master tape in which the pieces of the double-faced adhesive tape cut into the substrate shape is joined and supported onto the carrier tape travels and is folded back with the edge knife. At this time, the piece of the double-faced adhesive tape is fed out while being separated from the carrier tape at a tip of the edge knife. A front end of the piece of the double-faced adhesive tape is pressed against the substrate moving at a speed synchronized to the feeding speed with use of a joining roller, whereby the piece of the double-faced adhesive tape having the same shape as the substrate is joined to the surface of the substrate.

Moreover, when the poor joining that the piece of the double-faced adhesive tape is protruded from the substrate is detected in an inspection process after the joining process, the defective substrate is transported to the tape separation mechanism without being collected for performing a tape separation process. The substrate reproduced through separating and removing the piece of the double-faced adhesive tape is immediately returned to the tape joining position via a transport path same as that where the piece of the double-faced adhesive tape is transported from the tape joining position to the tape separation mechanism. Then, the double-faced adhesive tape is again joined.

Accordingly, it is not necessary to prepare a receptacle and a place for storing the defective substrates, a transport mechanism for transporting a reproduced substrate exclusively, etc. Moreover, the defective substrate may immediately be reproduced.

Moreover, the method further includes the steps of separating a separator from a piece of the double-faced adhesive tape after joining a separation tape to the separator on the piece of the double-faced adhesive tape on the defective substrate; and separating and removing the piece of the double-faced adhesive tape from the substrate after joining a separation tape to the piece of the double-faced adhesive tape from which the separator is separated.

According to this method, when a first separation for the separator is performed, the separator on the uppermost layer of the piece of the double-faced adhesive tape joined to the substrate is firstly separated and removed, whereby, a double-faced adhesive tape body is exposed. When a second separation for the double-faced adhesive tape is performed, the double-faced adhesive tape body itself is separated and removed from the substrate. Accordingly, the substrate is renewable.

Here, in the separation step, the separator and the double-faced adhesive tape body may be separated readily without applying adhesion reduction processing (e.g., ultraviolet irradiation or heating) to the double-faced adhesive tape body by joining the separation tape of strong adhesion to the separator and the double-faced adhesive tape body, and collecting and winding up the separation tape.

Moreover, the separating step in the foregoing method may further include the step of separating a separator from the piece of the double-faced adhesive tape after joining the separation tape on the piece of the double-faced adhesive tape on a non-defective substrate from which no piece of the double-faced adhesive tape protrudes.

According to this method, the separator may be separated and removed from the substrate having the piece of the double-faced adhesive face properly joined thereto, and the substrate may be transported and collected while the separator is separated and an adhesive surface of the double-faced adhesive tape body is exposed. That is, it becomes possible to immediately join the support substrate for reinforcement to the substrate.

This invention also adopts the configuration as stated below to accomplish such object. That is, this invention discloses double-faced adhesive tape joining apparatus for joining a double-faced adhesive tape to a substrate. The apparatus includes a tape traveling guidance mechanism for traveling an original master tape to an edge knife, the original master tape being formed by joining pieces of the double-faced adhesive tape with separators, that are cut into a shape of the substrate, to a long carrier tape; a joining table for holding the substrate; a table driving mechanism for moving the joining table relative to the edge knife at a speed synchronized to a tape traveling speed; a tape joining mechanism provided with a joining roller for pressing against the substrate on the joining table the piece of the double-faced adhesive tape in the substrate shape that is separated from the carrier tape through folding back and traveling the original master tape with a tip of the edge knife; an inspection mechanism for inspecting protrusion of the piece of the double-faced adhesive tape joined on the substrate; a separation table for holding the substrate having the piece of a double-faced adhesive tape joined thereto; a tape separation mechanism for separating the double-faced adhesive from the substrate held on the separation table; and a substrate transport mechanism for transporting the substrate from the joining table and the separation table.

With this configuration, the foregoing method may be suitably performed.

Moreover, the inspection mechanism includes a pair of monitoring cameras for monitoring a periphery of the piece of the double-faced adhesive tape joined to the substrate held on the joining table. Such configuration is preferable.

According to this configuration, monitoring may be made of deviation in position of the piece of the double-faced adhesive tape to the substrate as well as a cutting condition on the periphery of the piece of a double-faced adhesive tape, which results in proper inspection on poor joining.

It is to be understood that both the foregoing general description and the following detailed description are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate embodiments of the invention, and together with the description serve to explain the principles of the invention.

Figure 1 is a plan view of double-faced adhesive tape joining apparatus.

Figure 2 is a side view showing main components of the apparatus.

Figure 3 is a perspective view showing main components of the apparatus.

Figures 4A to 4C are schematic side views each showing operations of a tape pre-cut mechanism.

Figure 5 is a plan view of a tape joining section.

Figure 6 is a plan view of a joining table.

Figure 7 is a side view of the joining table.

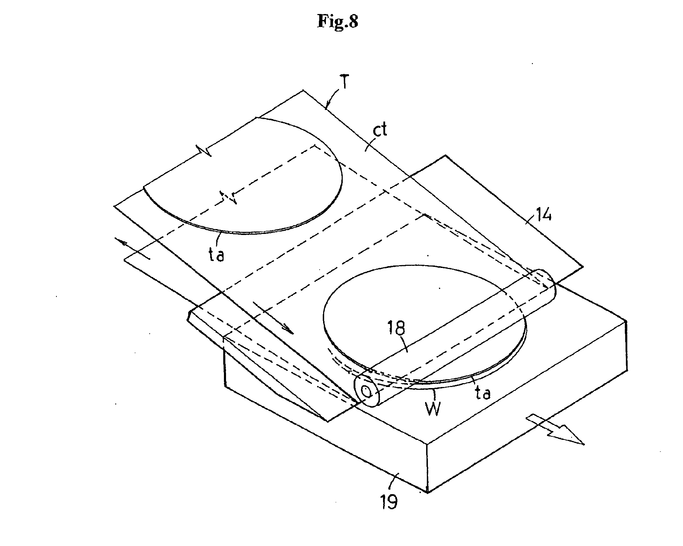

Figure 8 is a perspective view of the tape joining section.

Figures 9A and 9B are schematic side views each showing operations of joining a double-faced adhesive tape.

Figure 10 is a side view of a tape separating section.

Figure 11 is a schematic side view showing operations of separating a separator.

Figure 12 is a schematic side view showing operations of separating a poorly joined double-faced adhesive tape.

### DESCRIPTION OF THE PREFERRED EMBODIMENTS

One embodiment of this invention is now to be described below with reference to the drawings.

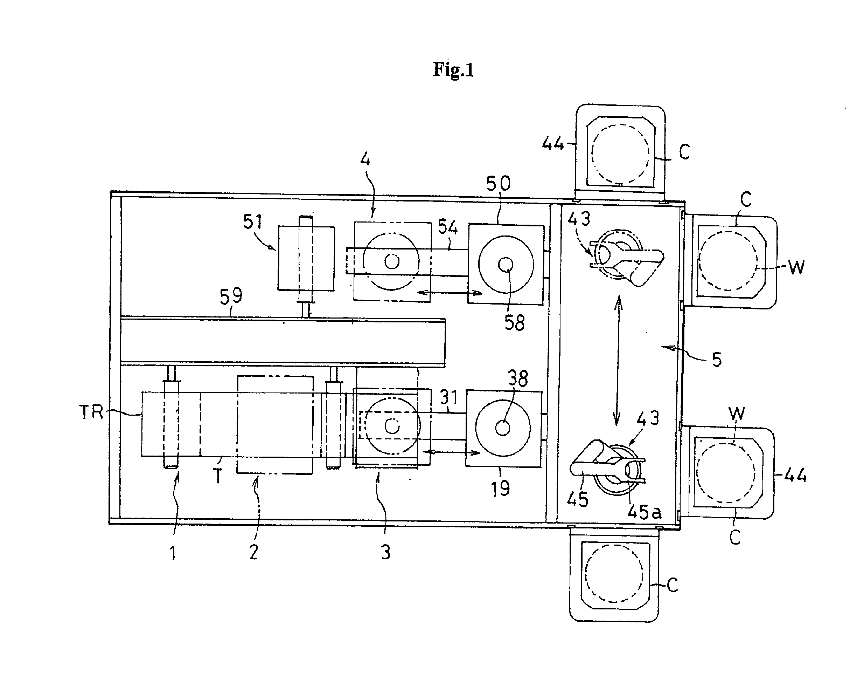

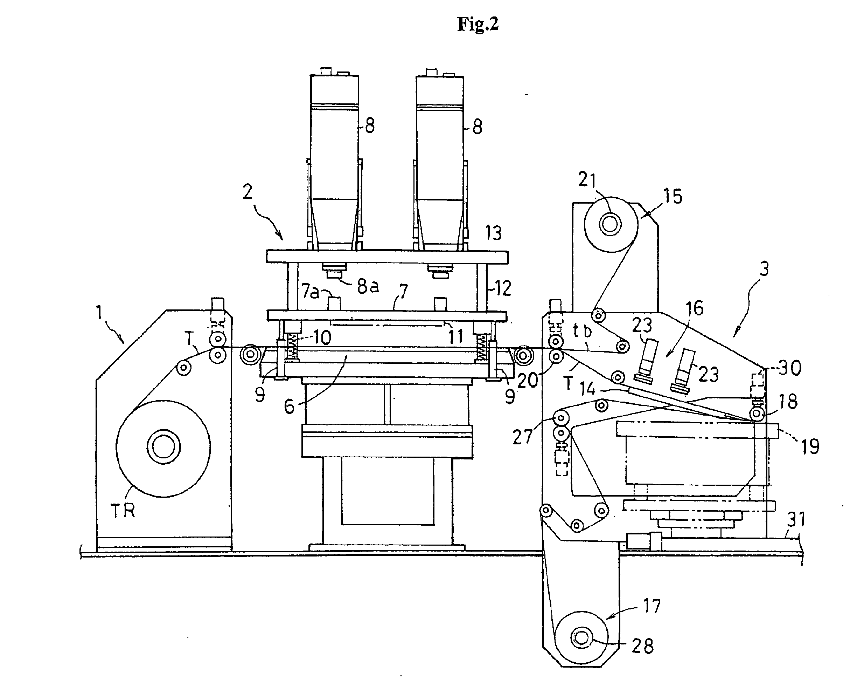

Figure 1 is a schematic plan view of double-faced adhesive tape joining apparatus according to this invention. Figure 2 is a side view of main components thereof.

The double-faced adhesive tape joining apparatus joins a double-faced adhesive tape for joining a support substrate for reinforcement to a surface of a semiconductor wafer W (hereinafter, simply referred to as a "wafer W"), which is one example of a substrate. A tape supply unit 1, a tape pre-cut mechanism 2, and a tape joining section 3 are placed in series in the longitudinal direction (in the left-right direction in Figure 1) of the apparatus. A tape separating section 4 is placed on the lateral side (the upper side in Figure 1) of the tape joining section 3. A long substrate transportation section 5 is placed in the left-right direction (a vertical direction in Figure 1) as to face toward the tape joining section 3 and the tape separating section 4. The apparatus has such basic configuration as above. In addition, a tape traveling guidance mechanism, such as a feed roller and a guide roller, is configured from the tape supply unit 1 to the tape joining section 3.

As shown in Figure 2, the tape supply unit 1 feeds out an original master tape T from an original master roll TR in a roll form. The original master tape T is guided on a given tape path via the tape pre-cut mechanism 2 to the tape joining section 3.

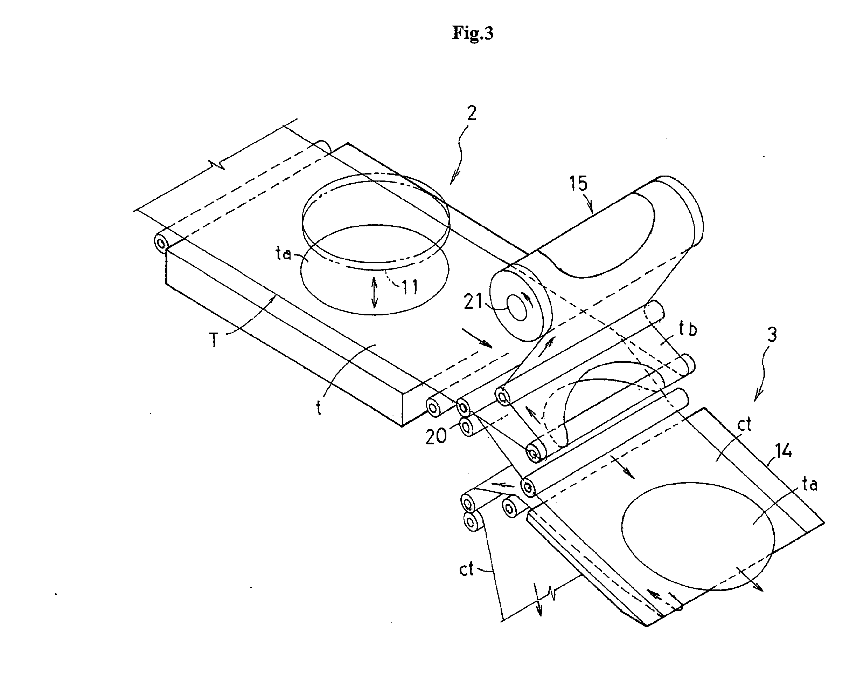

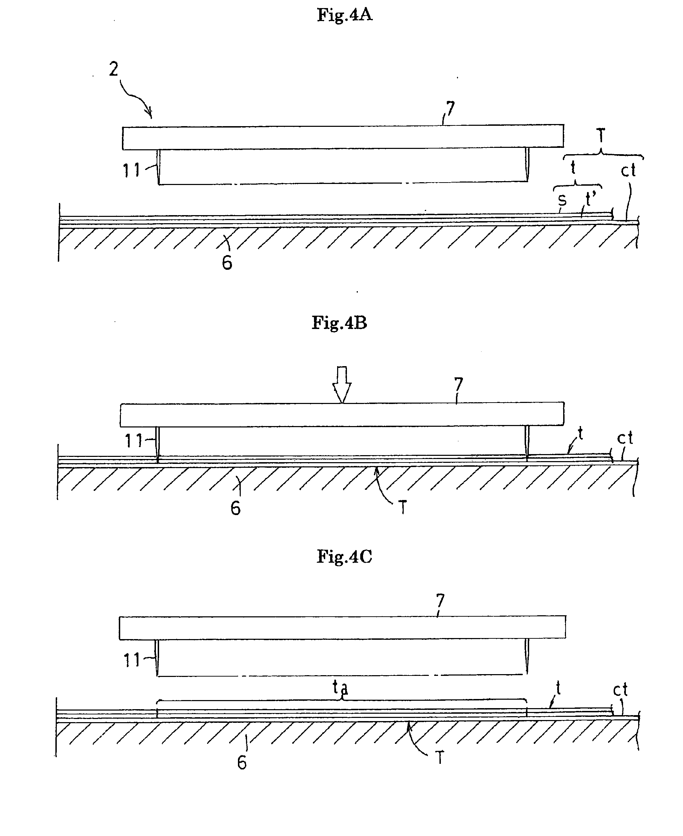

As shown in Figures 3 and 4, the original master tape T is formed of a carrier tape ct having a larger width than a diameter of a wafer W and a double-faced adhesive tape t having the same width as the carrier tape ct that are joined to each other. The double-faced adhesive tape t itself is formed through joining a separator s on one adhesive surface directed upward of a double-faced adhesive tape body t' having upper and lower adhesive surfaces.

As shown in Figure 2, the tape pre-cut mechanism 2 includes a tape supporting table 6, a blade holder 7, and a driving cylinder 8. The tape supporting table 6 is fixedly provided as to receive the original master tape T horizontally that is transported from the original master roll TR. The blade holder 7 is arranged as to move upward and downward above the tape supporting table 6. The driving cylinder 8 is provided above the blade holder 7 that allows the blade holder to move upward and downward.

The blade holder 7 is supported via a slide guide shaft 9 as to move upward and downward while maintaining a horizontal attitude. Moreover, the blade holder 7 is biased upward in a given standby position through a return spring 10. The blade holder 7 has an annular Thomson blade 11 on a lower surface thereof with a corresponding contour to the wafer to be processed.

The driving cylinder 8 is attached vertically on a stand 13 fixed via a strut 12 on the tape supporting table 6. Moreover, a plunger 8a projects downward to contact a shank 7a projecting from an upper surface of the blade holder 7, whereby a force against upward return bias is applied to the blade holder 7 to move the driving cylinder 8 downward. At this time, the Thomson blade 11 is pressed against the original master tape T on the tape supporting table 6. In this embodiment, four driving cylinders 8 are attached along a given circumference at equal intervals on the stand 13.

As shown in Figures 2 and 3, the tape joining section3 includes a wide edge knife 14, an unnecessary adhesive tape collecting section 15, a tape position monitoring mechanism 16, a carrier tape collecting section 17, a joining roller 18, and a joining table 19. The wide edge knife 14 folds back and guides the half-cut original master tape T transported from the tape pre-cut mechanism 2. The unnecessary adhesive tape collecting section 15 separates and winds up and collects a band-shaped double-faced adhesive tape tb that remains around the cut-out pieces ta of the double-faced adhesive tape in front of the edge knife 14. The tape position monitoring mechanism 16 is located above the edge knife 14. The carrier tape collecting section 17 winds up and collects the carrier tapes ct folded back downward with the edge knife 14. The joining roller 18 faces from an upper side toward a tip of the edge knife 14. The joining table 19 is arranged below the edge knife 14 as to reciprocate horizontally.

The unnecessary adhesive tape collecting section 15 separates from the carrier tape ct the unnecessary double-faced adhesive tape tb remaining around the cut piece ta of the double-faced adhesive tape in the wafer shape immediately after the tape transport roller 20, and winds up the unnecessary double-faced adhesive tape tb onto a collection bobbin 21. Accordingly, the original master tape T having the piece ta of the double-faced adhesive tape remaining on the carrier tape ct with the separator is guided to the edge knife 14.

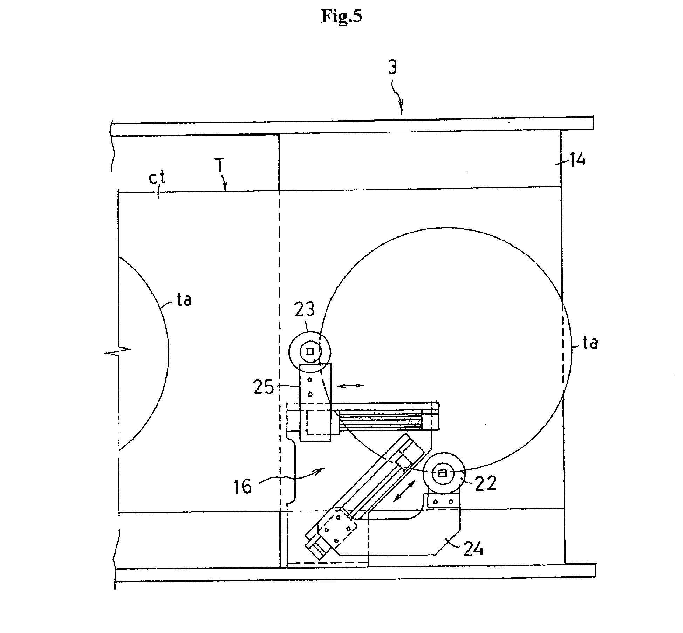

The tape position monitoring mechanism 16 detects one end of the piece ta of the double-faced adhesive tape in a tape width direction (the left-right direction) that is cut out into the wafer shape, and front and rear ends of the piece ta of the double-faced adhesive tape in a tape traveling direction using monitoring cameras 22 and 23, respectively. As shown in Figure 5, the monitoring cameras 22 and 23 are supported on movable brackets 24 and 25, respectively, that move linearly in a screw feed manner. Positional information on a lateral end and front and rear ends of the piece ta of the double-faced adhesive tape may be obtained through determining movement zones where the ends of the piece ta of the double-faced adhesive tape has been detected. Obtained information is sent to a controller.

As shown in Figure 2, the carrier tape collecting section 17 drives to send the carrier tape ct folded back up by the edge knife 14 with a roller 27, and wind it up with a collection bobbin 28.

A driving cylinder 30 moves upward and downward the joining roller 18. Accordingly, the joining roller 18 presses the upper surface of the piece ta of the double-faced adhesive tape with the separator that is separated from the carrier tape ct at the tip end of the edge knife 14 against the upper surface of the wafer W that is suction-held on the joining table 19 and moves horizontally. Here, the joining roller 18 and the driving cylinder 30 constitute the tape joining mechanism in this invention.

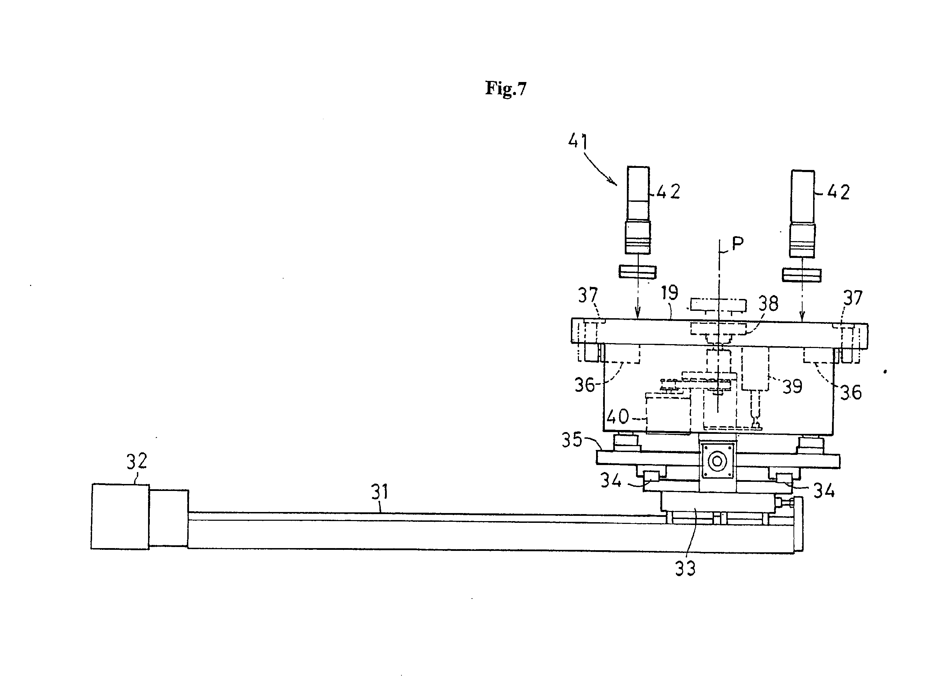

The joining table 19 is movable in the longitudinal and left-right directions. That is, as shown in Figures 2 and 7, a rail 31 is longitudinal horizontally installed as to extend under the edge knife 14. The joining table 19 includes a front-to rear direction movable board 33 that moves in a screw feed manner along the rail 31 via a motor 32. Rails 34 are fixed in parallel on both sides of the front-to rear movable board 33. A left-to-right movable board 35 is provided that moves in a screw manner along the rails 34 via a motor, not shown. Moreover, the left-to-right movable board 35 includes a joining table 19 thereon.

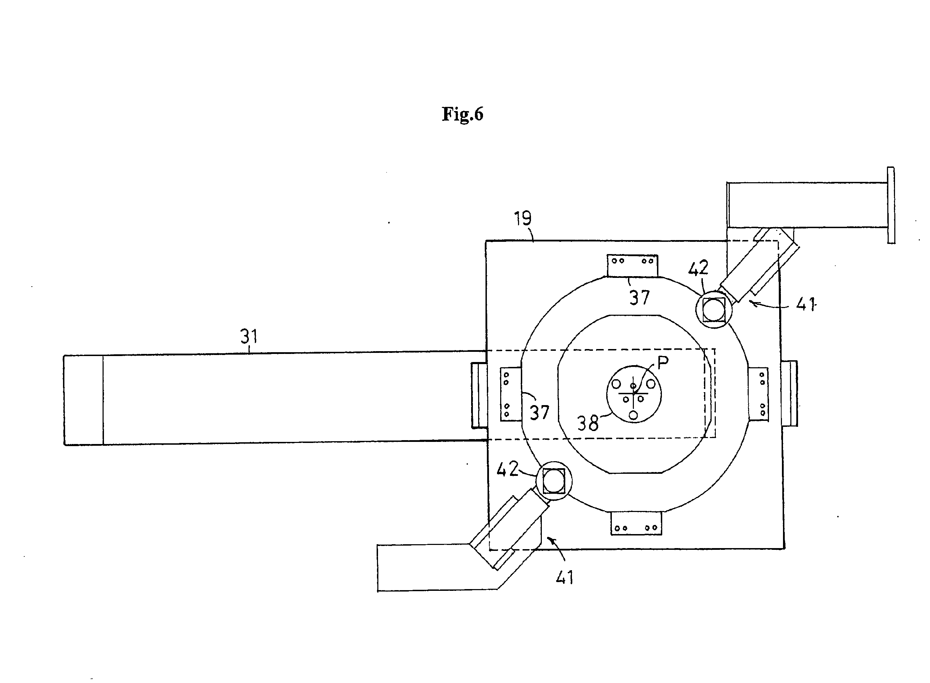

As shown in Figure 6, positioning members 37 are arranged at four points along four sides of the joining table 19 as to move in and out toward the center of the table via a cylinder 36. The positioning members 37 press an outer periphery of the wafer W placed on the joining table 19 at four points toward the center of the table, thereby positioning the wafer W on the center of the table.

The joining table 19 includes at the center thereof a suction pad 38 having an upper surface formed as a vacuum-suction surface. As shown in Figure 7, a cylinder 39 drives the suction pad 38. The suction pad 38 is interlocked with a motor 40 via a belt to rotate about a vertical axis P through the center of the joining table 19.

A joining inspection mechanism 41 is positioned above the joining table 19. The joining inspection mechanism 41 has a pair of monitoring cameras 42 for monitoring a diagonal circumference of the wafer W to detect positional deviation of the piece ta of the double-faced adhesive tape relative to the wafer W and finishing condition of a cutting edge of the piece ta of the double-faced adhesive tape (sharpness).

As shown in Figure 1, the substrate transportation section 5 includes a transportation robot 43 movable horizontally. The substrate transportation section 5 includes around thereof two or more cassettes C and supporting boards 44 for cassette C that are each movable upward and downward. The supporting board 44 is provided for the cassette C into which wafers W prior to joining of the double-faced adhesive tape t are inserted and housed in a stack manner, and another supporting board 44 is for the cassette C into which the wafers W subject to joining of the double-faced adhesive tape t are inserted and housed.

The transportation robot 43 includes a robot arm 45 that is bendable horizontally and rotatable in all directions. The robot arm 45 has at a free end thereof a suction section 45a in a U-shape with an upper surface thereof formed as a vacuum-suction surface.

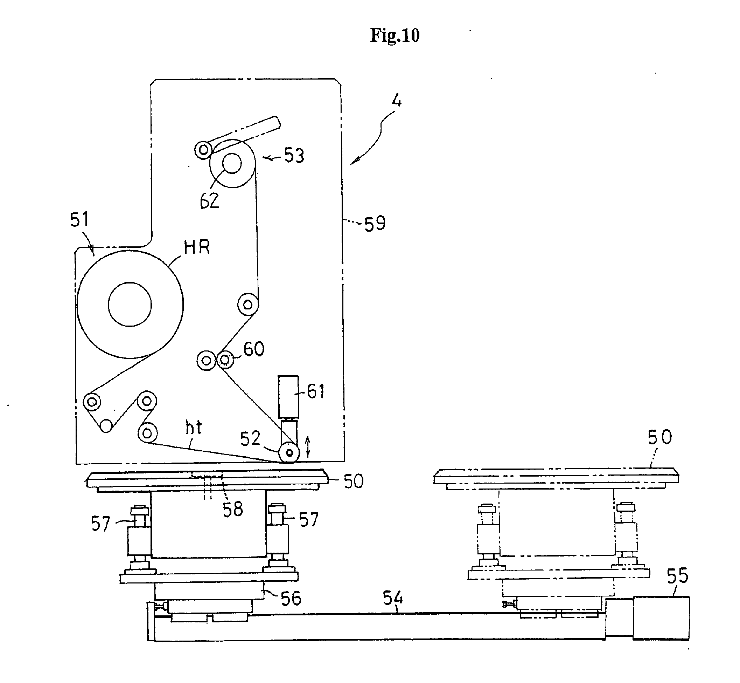

As shown in Figure 10, the tape separation section 4 includes a separation table 50, a separation tape supply unit 51, a separation roller 52, and a separation tape collecting section 53.

The separation table 50 is movable longitudinal horizontally and vertically. Specifically, a movable board 56 is provided that moves via a motor 55 in a screw-feed manner along rails 54 located longitudinal horizontally. The separation table 50 is held on the movable board 56 via a guide shaft 57 as to move vertically. In addition, the suction pad 58 is provided on a center of the separation table 50 as to transport the wafer W.

The separation table 51, the separation roller 52, and the separation tape collection section 53 are provided on a frame plate 59 fixed above a side of a separation table moving path.

The separation tape supply unit 51 feeds out a separation tape ht from an original master roll HR to guide it through the separation roller 52 to a feed roller 60. Here, the separation tape ht is wound up on the separation roller 52 having the adhesive surface thereof being directed downward. Here, the separation tape ht is wound up on the separation roller 52 having the adhesive surface thereof being directed downward.

The separation roller 52 is positioned below the frame plate 59 as to face toward the separation table 50. A cylinder 61 moves the separation roller 52 upward and downward.

The separation tape collecting section 53 winds up on a collection bobbin 62 the separation tape ht directed upward that is fed out from the feed roller 60, and collects it.

The double-faced adhesive tape joining apparatus according to this invention is configured as above. Description will be given of a series of operations of joining the double-faced adhesive tape to the surface of the wafer using the apparatus with reference to drawings.

In the substrate transportation section 5, the robot arm 45 of the transportation robot 43 is inserted into a given cassette C mounted on the supporting board 44. The robot arm 45 suction-holds a rear face of one housed wafer W, and pulls out the wafer W having the surface directed upward. The robot arm 45 transports the wafer W above the joining table 19 in front of the tape joining section 3 in a standby state.

The joining table 19 has the suction pad 38 projecting therefrom in a standby state. The robot arm 45 temporally places the transported wafer W to the suction pad 38. The robot arm 45 retracts from the joining table 19. The suction pad 38 moves downward to place the wafer W on the holding table 19.

The wafer W is placed on the joining table 19, and then the positioning members 37 on the four sides each move toward the center of the table to position the wafer W on the center of the table. The vacuum pump, not shown, operates with the wafer W positioned as above to suction-hold the wafer W on the joining table 19. Thereafter, the joining table 19 moves backward to a given position below the tape joining section 3.

In the tape pre-cut mechanism 2 as shown in Figure 4A, the Thomson blade 11 is located above the tape supporting board 6 in a standby position. Then, the driving cylinder 8 operates to move the blade holder 7 downward due to a force against a bias force of the return spring 10 to press the Thomson blade 11 against the original master tape T stopping on the tape supporting board 6. Here, as shown in Figure 4, the blade holder 7 has lower limitation on downward movement such that the Thomson blade 11 only cuts the double-faced adhesive tape t with the separator s on the original master tape T and does not entirely cut the carrier tape ct. The Thomson blade 11 cuts the double-faced adhesive tape t, and thereafter returns to its standby position as in Figure 4C. The double-faced adhesive tape t is cut into the wafer shape, and then the original master tape T is fed forward.

Only a unnecessary portion of the double-faced adhesive tape tb having a cut-out hole is separated from the carrier tape ct and collected in the unnecessary adhesive tape collecting section 15. In this case, the piece ta of the double-faced adhesive tape cut out into the wafer shape remains on the carrier tape ct.

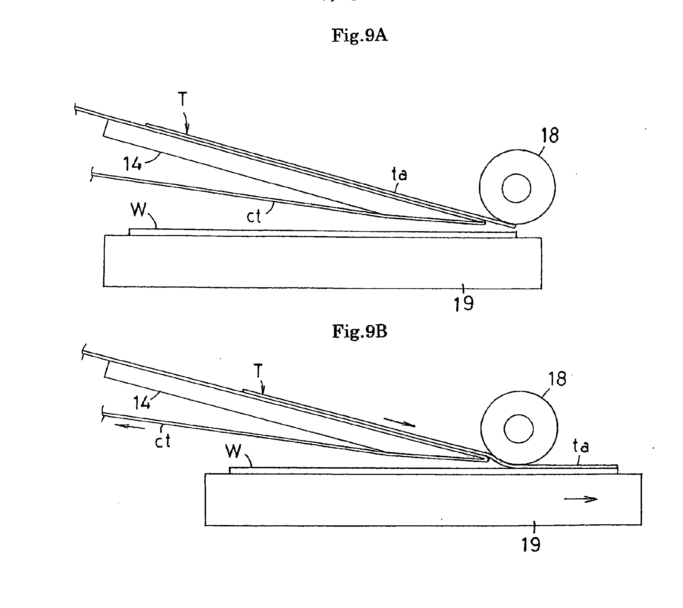

The original master tape T having only the piece ta of the double-faced adhesive tape joined to the carrier tape t travels and is folded back with the edge knife 14. Here, the piece ta of the double-faced adhesive tape is separated from the carrier tape ct that is folded back while traveling. Accordingly, the piece ta of the double-faced adhesive tape travels forward along an upper surface of the edge knife 14. Thereafter,
as shown in Figure 9A, a front end of the piece ta of the double-faced adhesive tape moves across the tip end of the edge knife 14. When the front end arrives immediately below the joining roller 18 in the standby position, the tape temporarily stops traveling.

Here, the monitoring cameras 22, 23 detect a front end, side ends, and a rear end of the piece ta of the double-faced adhesive tape, in this order, that is fed to the tape joining section 3 with the carrier tape ct. Specifically, the monitoring camera 23 acquires an image of the front end. The monitoring camera 22 acquires images of the side ends. The monitoring camera 23 acquires an image of the rear end. Positional information is obtained through each of the images, and is sent to a controller.

The controller determines position coordinates of an outer periphery of the wafer W from each portion of the piece ta of the double-faced adhesive tape in each image. Determination is made of deviation in positional direction and amount between the piece ta of the double-faced adhesive tape and the wafer held on the joining table 19 in accordance with each position coordinate of the piece ta of the double-faced adhesive tape. That is, a distance of the piece ta of the double-faced adhesive tape in the transportation direction is calculated from each coordinate of the front and rear ends of the piece ta of the double-faced adhesive tape. A position where the distance is the maximum is determined as a tip. Deviation in positional direction and amount is determined from pattern matching of the position of the tip calculated in advance, the image of the side ends, and a reference image acquired in advance.

The controller controls the joining table 19 as to operate longitudinal horizontally, in the left-right direction, and about the vertical axis P in accordance with calculated deviation in direction and amount of the piece ta of the double-faced adhesive tape, thereby correcting a joining position.

Subsequently, the joining roller 18 moves downward to press the front end of the piece ta of the double-faced adhesive tape protruding forward from the edge knife 14 against a front end surface of the wafer W held on the joining table 19. Thereafter, as shown in Figure 9B, the tape starts traveling again. The joining table 19 moves at a speed synchronized to a forward movement speed of the piece ta of the double-faced adhesive tape that moves forward while being separated from the carrier tape ct. That is, joining roller 18 successively joins the piece ta of the double-faced adhesive tape separated from the carrier tape ct on the surface of the wafer W.

Upon completion of joining the piece ta of the double-faced adhesive tape, the joining table 19 moves to a give standby position and then stops, where the joining inspection mechanism 41 inspects joining condition and cutting condition of the piece ta of the double-faced adhesive tape.

Specifically, when the joining table 19 reaches a position to transport the wafer W to the transportation robot 43 (on the right side of the rail in Figure 1), the suction pad 38 moves upward while suction-holding the wafer W and rotates about the vertical axis P. A pair of monitoring cameras 42 images an outer periphery of the wafer W during rotation. For instance, image data taken using one of the monitoring cameras 42 is sent to a controller. The controller determines real co-ordinates of the outer periphery of the wafer W taken with the monitoring camera 42. The real co-ordinates is compared with a reference co-ordinate memorized in advance in a memory of the controller. When no real co-ordinate matches with the reference co-ordinate, it is determined that some protrusion of the piece ta of the double-faced adhesive tape exists from the wafer W.

Similarly, another monitoring camera 42 images an outer periphery of the wafer W during rotation. The controller performs binarization to the image data, for instance. At this time, a mustache-like portion of the piece ta of the double-faced adhesive tape protrudes from the outer periphery of the wafer W due to poor cutting of the piece ta of the double-faced adhesive tape by wear of the Thompson blade 11. The protrusion appears in a different color from the portion and outside of the wafer W. That is, the portion of the wafer W becomes white due to reflection of light emitted toward the wafer W from an irradiation device. The outside of the wafer W becomes black as there exists no reflected light. The mustache-like portion from the end of the tape where poor cutting occurs becomes gray. Accordingly, the controller considers the wafer W in a poor-cut condition when a gray zone occurs in the outer periphery of the wafer through binarization.

When the above tape joining inspection is completed, the joining table 19 releases suction holding of the wafer W and the suction pad 38 moves upward. The transport robot 43 then transports the wafer W floating above the table toward to the tape separation section 4, and places the wafer W on the separation table 50 in a forward given standby position.

When the joining inspection mechanism 41 verifies that the wafer W placed on the separation table 50 is non-defective, the following process is to be performed.

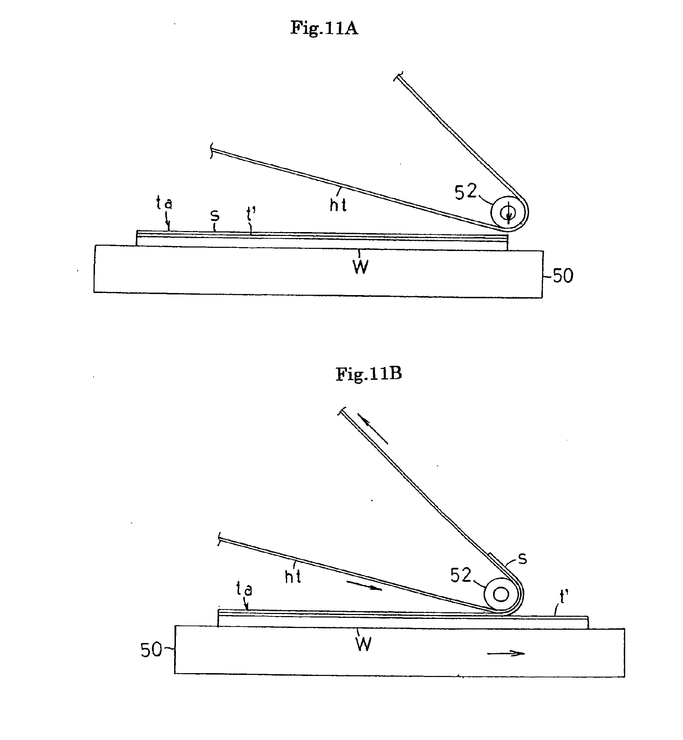

The separation table 50 having the wafer W placed and suction-held thereon once moves backward (to the left in Figure 1.) Thereafter, as shown in Figure 11A, the table stops when the end of the wafer W reaches immediately below the separation roller 52. The separation roller 52 moves downward to press the separator s of the piece ta of the double-faced adhesive tape having an adhesive surface of the separation tape ht joined to the upper surface of the wafer W, the adhesive surface being directed downward. Thereafter, as shown in Figure 11B, the separation table 50 returns forward, and accordingly, the separation tape ht travels at a speed synchronized to return movement of the separation table 50 for collecting. That is, the separator s joined and held onto the separation tape ht is separated from the adhesive surface of a double-faced adhesive tape body t' in the piece ta of the double-faced adhesive tape directed upward due to return movement of the separation table 50. Accordingly, the separator s is wound up and collected together with the separation tape ht.

Upon completion of separating and removing the separator s from the double-faced adhesive tape body t', the separation roller 52 returns upward and the separation table 50 returns to its original standby position and then stops. Here, when a prior inspection verifies proper joining of the piece ta of the double-faced adhesive tape, the transportation robot 43 transports the wafer W from the separator table 50 to insert and house it into a given cassette C.

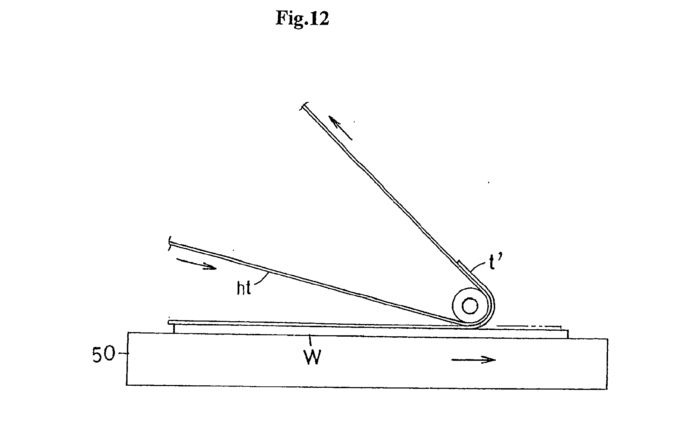

When it is verified that the piece ta of the double-faced adhesive tape placed on the separation table 50 is not joined properly to the wafer W, the same operation as the foregoing separation of the separator s is to be repeated. Specifically, the separation table 50 moves and temporally stops as to position the separation roller immediately below the wafer W. The separation roller 52 moves downward to press the separator s of the piece ta of the double-faced adhesive tape having an adhesive surface of the separation tape ht joined to the upper surface of the wafer W, the adhesive surface being directed downward. Thereafter, as shown in Figure 12, the separation table 50 returns forward, and accordingly, the separation tape ht travels at a speed synchronized to return movement of the separation table 50 for collection. That is, the separation tape ht is joined to the double-faced adhesive tape body t' in the piece ta of the double-faced adhesive tape remaining on the upper surface of the wafer W due to return movement of the separation table 50. The separation tape ht is wound up and collected, whereby the double-faced adhesive tape body t' is separated from the wafer W with the separation tape ht, and then wound up and collected.

Twice separation may realize separation and removal of the piece ta of the double-faced adhesive tape in a poor-joining condition together with the separator s. Then, the transportation robot 43 transports the wafer W having an exposed surface from the separation table 50. The transport robot 43 moves and mounts the renewed wafer W onto the joining table 19 in a standby state in a receiving position of the joining inspection mechanism 41. The joining table 19 moves to a joining position of the piece ta of the double-faced adhesive tape. Thereafter, joining and inspection operations of the double-faced adhesive tape are to be performed in turn.

Thus, a round of operation is completed as mentioned above. The similar operation is to be repeated hereinafter.

According to the foregoing exemplary apparatus, the wafer W with the poorly joined piece ta of the double-faced adhesive tape is usually transported to the tape separating section 4. Two separation processes are performed to the separator s and the double-faced adhesive tape body t', in this order, to separate and remove them from the wafer W. The reproduced wafer W may be returned to the joining table 19 along the same transportation path as that where the wafer W is transported to the separation table 50. Such processes may be performed. Thus, the wafer W to which the tape is poorly joined in the double-faced adhesive tape joining apparatus may be reproduced quickly in the same apparatus as a series of processes. In other words, it is no need to prepare individual processes and apparatus for reproducing the wafer W to which the tape is poorly joined.

This invention may be embodied as the following aspects.

(1) In the foregoing embodiment, the wafer W may be collected without separating the separator s, and the separator s may be separated from the piece ta of the double-faced adhesive tape during the support substrate joining process.

(2) Substrates to be processed to which the double-faced adhesive tape t is to be joined include not only a semiconductor wafer in a circular shape but various substrates such as a rectangular glass substrate.

(3) In the foregoing embodiment, two monitoring cameras 42 provided in the joining inspection mechanism 41 are used for each acquiring image data on the outer periphery of the wafer W. Alternatively, one monitoring camera 42 may also be utilized in this embodiment. In this case, image data on the outer periphery of the wafer W acquired with one monitoring camera 42 is used to determine defective due to protrusion of the tape by coordinate conversion as above and to determine poor cutting with binarization. Alternatively, one monitoring camera 42 images the entire wafer W, and poor joining of the tape is determined from pattern matching of an acquired actual image and a reference image acquired in advance. Such configuration may be adopted.

(4) In this invention, the original master tape T prior to a cutting process is not cut is wound in a roll form, whereby the original master roll TR is formed. The original master tape T fed out from the original master roll TR is cut during being guided to the edge knife 14. Alternatively, the following configuration may be adopted.

That is, the original master tape T is half-cut in advance in the substrate shape at given pitches, and wound in a roll form, whereby the original master roll TR is formed. Then, the half-cut original master tape T is fed out from the original master roll TR. Subsequently, the piece ta of the double-faced adhesive tape is successively separated and joined while the half-cut original master tape T is fed out from the original master roll TR, an unnecessary portion of the double-faced adhesive tape is separated and collected, and the original master tape T having the piece ta of the double-faced adhesive tape joined thereto is folded back.

It will be apparent to those skilled in the art that various modifications and variations can be made in the present invention without departing from the spirit or scope of the invention. Thus, it is intended that the present invention cover the modifications and variations of this invention provided they come within the scope of the appended claims and their equivalents.

## Claims

1. A method of joining a double-faced adhesive tape to a substrate, comprising the steps of:
separating a piece of the double-faced adhesive tape with a separator cut out into a substrate shape from a long carrier tape through traveling and folding back an original master tape with an edge knife, the original master tape having the long carrier tape and the long double-faced adhesive tape joined thereto;
joining the separated piece of the double-faced adhesive tape to the substrate at a speed synchronized to a separation speed;
inspecting a protrusion of the joined piece of the double-faced adhesive tape from the substrate with an inspection mechanism;
separating and removing the piece of the double-faced adhesive tape from the defective substrate that is transported into a tape separation mechanism when a protrusion of the piece of the double-faced adhesive tape is detected;
reloading the substrate to be reproduced through returning the substrate, having the piece of the double-faced adhesive tape separated therefrom, into a tape joining position via a transport path same as that where the piece of the double-faced adhesive tape is transported from the tape joining position to the tape separation mechanism; and
reproducing the substrate to be reproduced through joining a piece of the double-faced adhesive tape again to the substrate in the joining step.

2. The method of joining the double-faced adhesive tape according to claim 1, further comprising the steps of:
separating a separator from a piece of the double-faced adhesive tape after joining a separation tape to the separator on the piece of the double-faced adhesive tape on the defective substrate; and
separating and removing the piece of the double-faced adhesive tape from the substrate after joining a separation tape to the piece of the double-faced adhesive tape from which the separator is separated.

3. The method of joining the double-faced adhesive tape according to claim 1,
wherein
the separating step further includes the step of separating a separator from the piece of the double-faced adhesive tape after joining the separation tape on the piece of the double-faced adhesive tape on a non-defective substrate from which no piece of the double-faced adhesive tape protrudes.

4. The method of joining the double-faced adhesive tape according to claim 1,
wherein
the inspection mechanism is formed of a monitoring camera to image an outer periphery of the substrate during rotation of the wafer;
a controller determines real co-ordinates of the outer periphery of the substrate using image data acquired from imaging to compare them with a reference co-ordinate determined in advance; and
it is determined that a protrusion of the piece of the double-faced adhesive tape exists from the substrate when no real co-ordinate matches with the reference co-ordinate.

5. The method of joining the double-faced adhesive tape according to claim 1,
wherein
the inspection mechanism is formed of an irradiation device and a monitoring camera to image an outer periphery of the substrate during rotation of the wafer;
a controller performs binarization to image data;
distinction is made of a protrusion of the tape from the outer periphery of the substrate, the substrate, and outside of the substrate in accordance with differences in level of reflected light; and
it is determined that the protrusion is defective.

6. The method of joining the double-faced adhesive tape according to claim 1,
wherein
the inspection mechanism is formed of an irradiation device and a pair of monitoring cameras to image an outer periphery of the substrate during rotation of the wafer;
a controller determines real co-ordinates of the outer periphery of the substrate using image data acquired with one of the monitoring cameras to compare them with a reference co-ordinate determined in advance;
it is determined that a protrusion of the piece of the double-faced adhesive tape exists from the substrate when no real co-ordinate matches with the reference co-ordinate
binarization is performed to image data acquired with the other monitoring camera;
distinction is made of a protrusion of the tape from the outer periphery of the substrate, the substrate, and outside of the substrate in accordance with differences in level of reflected light; and
it is determined that the protrusion is defective.

7. double-faced adhesive tape joining apparatus for joining a double-faced adhesive tape to a substrate, comprising:
a tape traveling guidance mechanism for traveling an original master tape to an edge knife, the original master tape being formed by joining pieces of the double-faced adhesive tape with separators, that are cut into a shape of the substrate, to a long carrier tape;
a joining table for holding the substrate;
a table driving mechanism for moving the joining table relative to the edge knife at a speed synchronized to a tape traveling speed;
a tape joining mechanism provided with a joining roller for pressing against the substrate on the joining table the piece of the double-faced adhesive tape in the substrate shape that is separated from the carrier tape through folding back and traveling the original master tape with a tip of the edge knife;
an inspection mechanism for inspecting protrusion of the piece of the double-faced adhesive tape joined on the substrate;
a separation table for holding the substrate having the piece of a double-faced adhesive tape joined thereto;
a tape separation mechanism for separating the double-faced adhesive from the substrate held on the separation table; and
a substrate transport mechanism for transporting the substrate from the joining table and the separation table.

8. The double-faced adhesive tape joining apparatus according to claim 7,
wherein
the inspection mechanism comprises a pair of monitoring cameras for monitoring a periphery of the piece of the double-faced adhesive tape joined to the substrate held on the joining table.
